# FASCICULE DE BREVET EUROPEEN

(11) **EP 3 711 101 B1**
(45) Date de publication et mention de la délivrance du brevet: **05.01.2022**
(21) Numéro de dépôt: 18842790.0
(22) Date de dépôt: 20.12.2018
(51) Int. Cl.: H01L 51/56, H01L 33/40, H01L 33/48

(54) **PROCÉDÉ DE FABRICATION D'UN DISPOSITIF ÉLECTROLUMINESCENT**
VERFAHREN ZUR HERSTELLUNG EINER ELEKTROLUMINESZENZVORRICHTUNG
METHOD FOR MANUFACTURING AN ELECTROLUMINESCENT DEVICE

(30) Priorité: 22.12.2017 FR 1763167
(43) Date de publication de la demande: 23.09.2020
(73) Titulaire: Commissariat à l'énergie atomique et aux énergies alternatives, 75015 Paris (FR)
(72) Inventeur: CHAMBION, Bertrand, 38530 PONTCHARRA (FR)
(74) Mandataire: Brevalex
(86) Numéro de dépôt international: PCT/FR2018/053437
(87) Numéro de publication internationale: WO 2019/122735

(56) Documents cités:
- WO-A1-2016/060676
- US-A1- 2012 161 183

## Description

### DOMAINE TECHNIQUE

La présente invention concerne un procédé de fabrication d'un dispositif électroluminescent. En particulier, la présente invention concerne un procédé de fabrication d'un dispositif électroluminescent mettant en œuvre un report des structures électroluminescentes par l'intermédiaire d'un substrat temporaire.

A cet égard, le procédé d'assemblage mettant en œuvre le substrat temporaire est exécuté au moyen d'une couche d'adhésion adaptée pour former une électrode commune aux structures électroluminescentes et pour absorber des contraintes mécaniques susceptibles s'apparaître lors du procédé de fabrication.

### ART ANTÉRIEUR

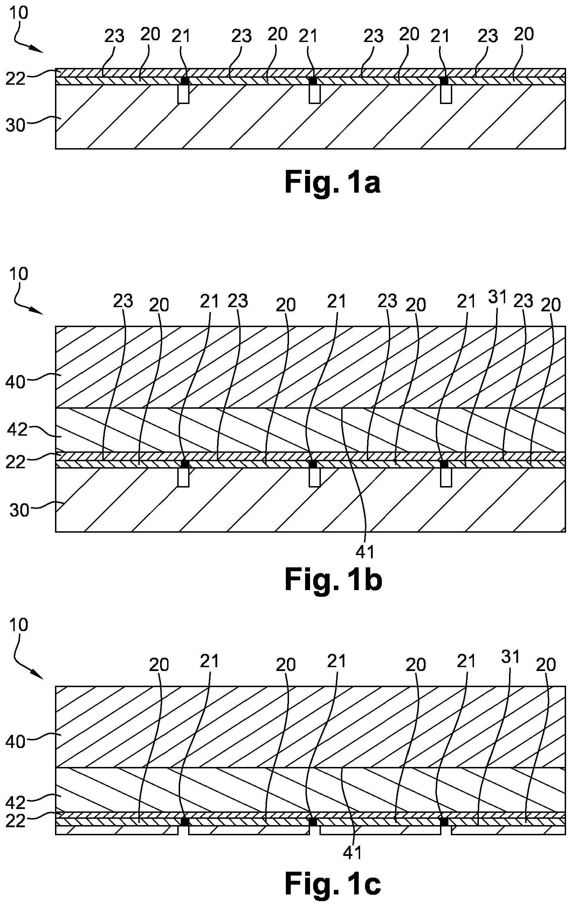

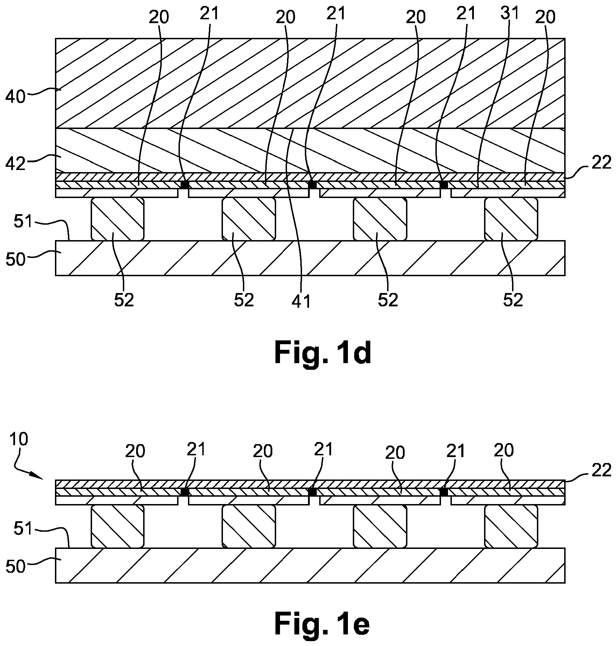

Un procédé de fabrication d'un dispositif électroluminescent 10, connu de l'état de la technique, est représenté aux figures la à le. Il comprend les étapes suivantes :
a) la formation de structures électroluminescentes 20 sur une face, dite face avant 31, d'un premier substrat 30, lesdites structures électroluminescentes 20 sont séparées les unes des autres par des tranchées 21, et comprennent une électrode commune 22 les connectant électriquement selon leur face libre 23 (figure la) ;
b) un premier assemblage des structures électroluminescentes 20 avec une face, dite face temporaire 41, d'un substrat temporaire 40 au moyen d'une couche d'adhésion 42 (figure 1b) ;
c) un amincissement, au moins partiel, du premier substrat 30 destiné à découvrir les tranchées 21 (figure 1c) ;
d) un second assemblage des structures électroluminescentes 20 avec une face, dite face d'accueil 51, d'un substrat d'accueil 50, le substrat d'accueil 50 comprenant des moyens d'interconnexion 52, qui en combinaison avec l'électrode commune 22, sont agencés pour adresser de manière individuelle chacune des structures électroluminescentes 20 (figure 1d) ;
e) un retrait total du substrat temporaire 40 et de la couche d'adhésion 42 (figure le).

A l'issue de l'étape e), les structures électroluminescentes 20 sont en contact avec les moyens d'interconnexion 52 par leur face opposée à la face libre 23, dite face de contact.

Les structures électroluminescentes 20 peuvent comprendre des diodes électroluminescentes susceptibles d'émettre un rayonnement lumineux par leur face libre.

Les diodes électroluminescentes peuvent être des diodes électroluminescentes 2D, à savoir planaires, et ainsi comprendre un empilement de films semi-conducteurs.

De manière alternative, les diodes électroluminescentes peuvent être des diodes électroluminescentes 3D comprenant, chacune, une pluralité de nanofils électroluminescents perpendiculaires à la face libre 23.

Cependant, ce procédé de fabrication connu de l'état de la technique n'est pas satisfaisant.

En effet, l'électrode commune est généralement une couche de métal ou de semi-conducteur dopé, qui recouvre les tranchées 21 de manière à assurer une continuité de la connexion électrique entre les faces libres 23 des structures électroluminescentes 20.

Cependant, l'électrode commune 22 présente, à l'endroit même du recouvrement des tranchées 21, une zone de faiblesse mécanique qui concentre toutes les contraintes pouvant survenir lors des différentes étapes du procédé de fabrication du dispositif électroluminescent 10.

De telles contraintes sont notamment observées à l'issue du second assemblage, et ont pour origine la non planéité des faces mises en contact, cette non planéité étant en particulier induite par les moyens d'interconnexion 52 disposés sur la face d'accueil.

Aussi, une trop forte concentration desdites contraintes peut mener à une rupture de l'électrode commune 22 (en d'autres termes à une discontinuité électrique), et par voie de conséquence, à une impossibilité d'adresser individuellement les structures électroluminescentes 20.

Par ailleurs, l'étape e) de retrait du substrat temporaire 40 est également accompagnée d'un retrait de la couche d'adhésion 42 qui peut être long et coûteux à mettre en œuvre.

Un procédé pour la préparation d'un dispositif électroluminescent par le moyen d'un substrat temporaire est divulgué dans US 2012/161183 A1.

Un but de la présente invention est alors de proposer un procédé de fabrication plus simple à mettre en œuvre que le procédé de fabrication connu de l'état de la technique.

Un autre but de la présente invention est de proposer un procédé conférant à la structure électroluminescente une meilleure tenue mécanique.

Un autre but de la présente invention est de proposer un procédé de fabrication plus tolérant à la non planéité des faces mises en contact lors du second assemblage.

### EXPOSÉ DE L'INVENTION

Les buts de la présente invention sont, au moins en partie, atteints par un procédé de fabrication d'un dispositif électroluminescent, le procédé comprenant :
a) une première étape de formation d'une structure temporaire qui comprend une pluralité de structures électroluminescentes individuelles séparées les unes des autres par des tranchées et comprenant chacune une face, dite face électroluminescente, par laquelle lesdites structures sont susceptibles d'émettre un rayonnement lumineux, les structures électroluminescentes étant collées selon leur face électroluminescente, au moyen d'une couche d'adhésion sur une face, dite face temporaire, d'un substrat temporaire ;
b) une étape d'assemblage qui comprend la mise en contact des structures électroluminescentes selon une face opposée à la face électroluminescente dite face arrière, avec une face, dite face d'accueil, d'un substrat d'accueil ;
c) une étape de retrait, au moins partiel, du substrat temporaire ;
le procédé étant caractérisé en ce que la couche d'adhésion, qui comprend un matériau polymère organique électriquement conducteur et au moins partiellement transparent au rayonnement lumineux, est, au moins en partie, conservée à l'issue de l'étape c) et forme une électrode commune aux faces électroluminescentes dont l'épaisseur est supérieure à 20 nm, avantageusement supérieure à 500 nm, encore plus avantageusement supérieure à 1 µm.

Selon un mode de mise en œuvre, l'étape a) comprend la formation de la couche d'adhésion sur l'un ou l'autre du substrat temporaire ou d'un premier substrat, le premier substrat comprenant sur une de ses faces, dite première face, la pluralité de structures électroluminescentes.

Selon un mode de mise en œuvre, l'étape a) comprend en outre une étape d'assemblage, dite étape d'assemblage temporaire, du substrat temporaire et du premier substrat.

Selon un mode de mise en œuvre, l'étape a) comprend également le retrait au moins partiel du premier substrat.

Selon un mode de mise en œuvre, une couche intermédiaire comprenant un oxyde transparent conducteur est formée en contact direct des faces électroluminescentes de chacune des structures électroluminescentes.

Selon un mode de mise en œuvre, le procédé de fabrication comprend en outre la formation d'ouvertures traversantes dans la couche d'adhésion exposant partiellement les faces électroluminescentes, les ouvertures traversantes étant avantageusement formées par une étape de gravure sèche ou liquide.

Selon un mode de mise en œuvre, la formation des ouvertures traversantes est adaptée pour conserver une section de la couche d'adhésion recouvrant les tranchées et un contour d'une largeur prédéterminée des faces électroluminescentes.

Selon un mode de mise en œuvre, la formation des ouvertures des traversantes est exécutée soit au cours de l'étape a), soit à l'issue de l'étape c).

Selon un mode de mise en œuvre, la couche d'adhésion comprend des secondes tranchées formées de manière conforme aux tranchées, et comblées par un matériau conducteur, avantageusement le matériau conducteur comprend un oxyde transparent conducteur.

Selon un mode de mise en œuvre, le matériau polymère organique comprend au moins un des matériaux choisi parmi : Pedot PSS, poly(3,4-ethylenedioxythiophene): poly(styrenesulfonate) (Pedot :PSS), Poly(fluorene)s, polyphenylenes, polypyrenes, Polyazulenes, polynaphthalenes, poly(pyrrole)s (PPY), polycarbazoles, polyindoles, polyazepines, polyanilines (PANI), poly(thiophene)s (PT), poly(p-phenylene sulfide) (PPS), Poly(acetylene)s (PAC), Poly(p-phenylene vinylene) (PPV).

Selon un mode de mise en œuvre, les structures électroluminescentes comprennent, de leur face électroluminescente vers leur face arrière, une couche électroluminescente reposant sur un substrat support présentant une épaisseur inférieure à 10 µm, avantageusement inférieur à 5 µm.

Selon un mode de mise en œuvre, les structures électroluminescentes comprennent chacune une couche active intercalée entre une première couche de semi-conducteur et une seconde couche de semi-conducteur.

Selon un mode de mise en œuvre, la couche électroluminescente comprend une pluralité de nanofils perpendiculaires à la face électroluminescente.

Selon un mode de mise en œuvre, les structures électroluminescentes sont agencées de manière matricielle.

Selon un mode de mise en œuvre, le substrat temporaire n'est retiré que partiellement à l'étape c), et comprend un matériau dont la transmission optique dans le domaine de longueurs d'ondes couvert par le rayonnement lumineux est supérieure à 1%, avantageusement supérieure à 50%, encore plus avantageusement supérieure à 90%.

Selon un mode de mise en œuvre, le substrat d'accueil comprend, sur sa face d'accueil, des moyens d'interconnexion, qui en combinaison avec l'électrode commune, sont agencés pour adresser de manière individuelle chacune des structures électroluminescentes.

### BRÈVE DESCRIPTION DES DESSINS

D'autres caractéristiques et avantages apparaîtront dans la description qui va suivre du procédé de fabrication d'un dispositif électroluminescent selon l'invention, donnés à titre d'exemples non limitatifs, en référence aux dessins annexés dans lesquels :
- les figures la à le sont des représentations schématiques des étapes a) à e) d'un procédé de fabrication d'un dispositif électroluminescent connu de l'état de la technique ;
- les figures 2a à 2e sont des représentations schématiques des étapes a) à c) d'un procédé de fabrication d'un dispositif électroluminescent selon un premier mode de réalisation de la présente invention ;
- la figure 3 est une représentation schématique du dispositif électroluminescent obtenu selon une variante du premier mode de réalisation de la présente invention ;
- la figure 4 est une représentation schématique du dispositif électroluminescent obtenu selon un second mode de réalisation de la présente invention ;
- la figure 5 est une représentation graphique du potentiel de masse simulé (axe vertical en V) d'une électrode commune de 10 µm d'épaisseur et faite de Pedot :PSS, en fonction de la distance (axe horizontal, en m) du bord B (abscisse nulle) vers le centre C (abscisse égale à 0,014 m), la simulation étant exécutée en imposant une densité de courant de 7500 A/m² traversant ladite électrode.

### EXPOSÉ DÉTAILLÉ DE MODES DE RÉALISATION PARTICULIERS

L'invention décrite de manière détaillée ci-dessous met en œuvre un procédé de fabrication d'un dispositif électroluminescent. A cet égard, la présente invention propose un procédé de report de structures électroluminescentes, formées sur un premier substrat, vers un substrat d'accueil. En particulier, le report, selon la présente invention, implique un report intermédiaire des structures électroluminescentes par assemblage du premier substrat et d'un substrat temporaire au moyen d'une couche d'adhésion.

Selon la présente invention, la couche d'adhésion, conservée à l'issue du procédé de fabrication, forme une électrode commune aux faces électroluminescentes et est faite d'un matériau polymère transparent et conducteur électrique adaptée pour améliorer la tenue mécanique du dispositif électroluminescent par rapport aux dispositifs connus de l'état de la technique.

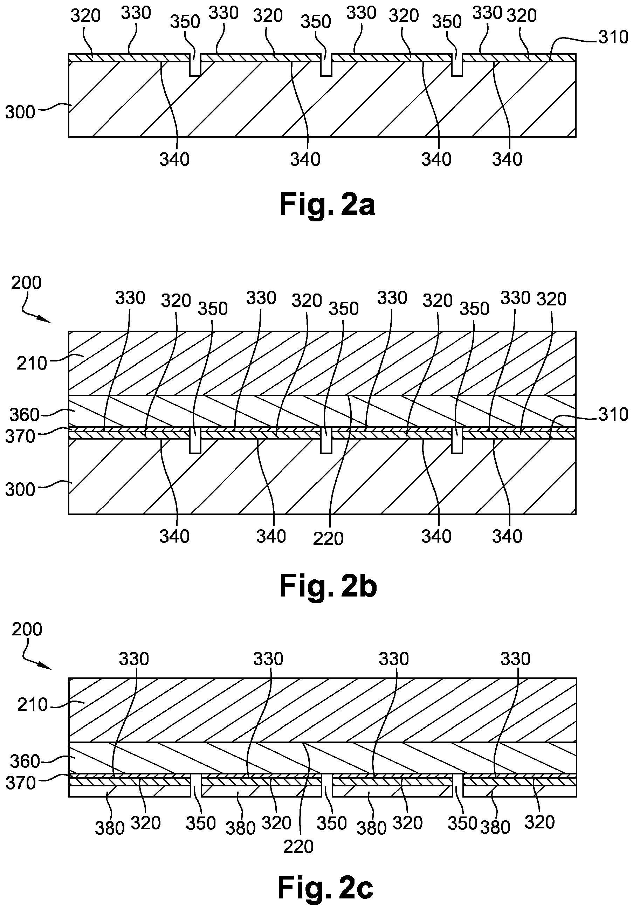

Aux figures 2a à 4, on peut voir des exemples de mise en œuvre du procédé de fabrication d'un dispositif électroluminescent 100 selon la présente invention.

Le procédé comprend une étape a) de formation d'une structure temporaire 200 (figure 2b).

La structure temporaire 200 comprend alors une pluralité de structures électroluminescentes 320, séparées par des tranchées 350, et chacune collées selon une face, dite face électroluminescente 330, sur une face, dite face temporaire 220, d'un substrat temporaire 210 au moyen d'une couche d'adhésion 360.

Le substrat temporaire 210 peut comprendre tout type de matériau, et en particulier du silicium, de la silice (verre) ou encore un métal.

Par « structure électroluminescente », on entend généralement une structure qui, dès lors qu'elle est traversée par un courant, émet un rayonnement lumineux.

A cet égard, les structures électroluminescentes 320 sont susceptibles d'émettre le rayonnement lumineux par leur face électroluminescente 330.

Par « rayonnement lumineux », on entend par exemple un rayonnement dans une gamme de longueurs d'ondes du domaine visible, par exemple dans une gamme de longueurs d'ondes comprise entre 400 nm et 800 nm.

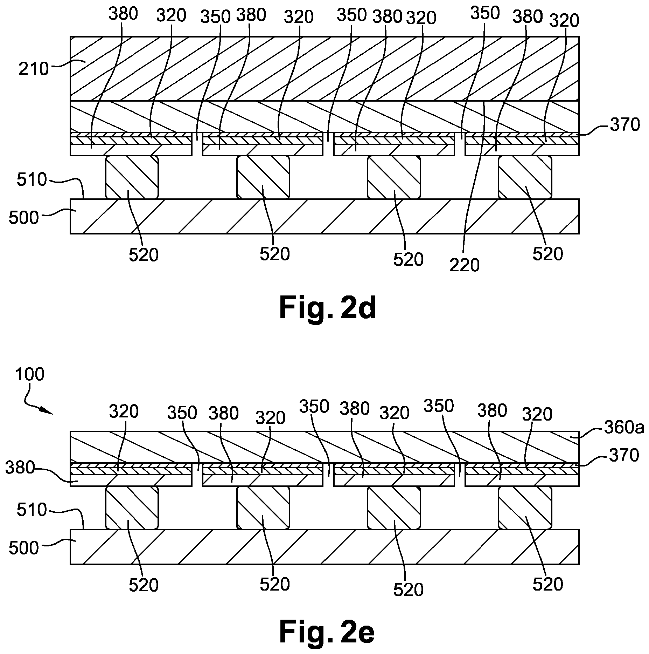

La couche d'adhésion 360 comprend un matériau polymère électriquement conducteur, et est destinée à former une électrode commune 360a aux faces électroluminescentes 330 (figures 2e, 3 et 4).

Par « électriquement conducteur », on entend généralement un matériau dont la conductivité électrique est supérieure à 10³ S/m, préférentiellement supérieure à 4^{∗}10⁵ S/m.

L'étape a) peut comprendre la formation de la couche d'adhésion 360 sur l'un ou l'autre du substrat temporaire 210 ou d'un premier substrat 300, qui comprend sur une de ses faces, dite première face 310, la pluralité de structures électroluminescentes 320 séparées par les tranchées 350 (figure 2a).

Il est alors entendu que la couche d'adhésion 360 peut être formée soit sur la face temporaire 220 ou en recouvrement des faces électroluminescentes 330 des structures électroluminescentes 320 et des tranchées 350.

L'étape a) peut, en outre, comprendre une étape d'assemblage, dite étape d'assemblage temporaire du substrat temporaire 210 et du premier substrat 300, la couche d'adhésion 360 se retrouvant ainsi intercalée entre le substrat temporaire 210 et le premier substrat 300.

Enfin l'étape a) peut comprendre une étape de retrait du premier substrat 300 (figure 2c).

L'étape de retrait peut être exécutée par amincissement du premier substrat 300, et en particulier par abrasion mécanique (« Grinding » selon la terminologie Anglo-Saxonne).

En particulier, le retrait du premier substrat 300 peut être complet, ou n'être que partiel de manière à laisser un reliquat, dit substrat support 380, dudit premier substrat sur les faces, dites faces arrières 340 des structures électroluminescentes 320, et opposées aux faces électroluminescentes 330.

L'épaisseur du substrat support 380 peut être inférieure à 20 µm, avantageusement inférieure à 10 µm, encore plus avantageusement inférieure à 5 µm.

Dans ce cas de figure, les tranchées 350 séparant les structures électroluminescentes 320 se prolongent en partie dans l'épaisseur du premier substrat 300, et l'étape de retrait partiel est exécutée de manière à découvrir lesdites tranchées 350.

Ainsi, à l'issue de l'étape de retrait, au moins partiel, du premier substrat 300, les structures électroluminescentes 320 se trouvent désolidarisées les unes des autres, et ne sont en contact qu'avec la couche d'adhésion 360 par leur face électroluminescente 330.

Selon une première alternative, les structures électroluminescentes 320 peuvent comprendre une couche active intercalée entre une première couche de semi-conducteur et une seconde couche de semi-conducteur.

La première couche de semi-conducteur peut comprendre du GaN de type n (par type n, on entend dopé avec des espèces donneuses d'électrons).

La seconde couche de semi-conducteur peut comprendre du GaN de type p (par type p, on entend dopé avec des espèces donneuses de trous).

La couche active peut comprendre au moins un des matériaux choisi parmi : GaN, GaAs, InGaN, InGaAIP.

La couche active, la première couche de semi-conducteur et la seconde couche de semi-conducteur peuvent être formées par des techniques de dépôt de films par épitaxie sur la première face 310 du premier substrat 300.

La formation desdites couches fait appel à des techniques connues de l'homme du métier et n'est donc pas décrite en détails dans la présente invention.

La formation desdits films peut également être suivie d'une étape de gravure destinée à former les tranchées 350.

Selon une seconde alternative, la structure électroluminescente 320 peut comprendre des nanofils ou des microfils perpendiculaires à la face électroluminescente 330.

Par « microfil » ou « nanofil », on entend une structure tridimensionnelle de forme allongée selon une direction privilégiée dont au moins deux dimensions, appelées dimensions mineures, sont comprises entre 5 nm et 2,5 µm, de préférence entre 50 nm et 2,5 µm, la troisième dimension, appelée dimension majeure, étant au moins égale à 1 fois, de préférence au moins 5 fois et encore plus préférentiellement au moins 10 fois, la plus grande des dimensions mineures. Dans certains modes de réalisation, les dimensions mineures peuvent être inférieures ou égales à environ 1 µm, de préférence comprises entre 100 nm et 1 µm, plus préférentiellement entre 100 nm et 300 nm. Dans certains modes de réalisation, la hauteur de chaque microfil ou nanofil peut être supérieure ou égale à 500 nm, de préférence comprise entre 1 µm et 50 µm.

Chaque nanofil microfil peut comprendre de façon non limitative un empilement formé, d'une zone d'InGaN-n, d'une zone active, d'une zone de GaN-p ou d'InGaN-p.

A cet égard, l'homme du métier peut consulter la demande de brevet [1] citée à la fin de la description, et plus particulièrement, de la page 19 ligne 24 à la page 20 ligne 10.

L'ensemble des nanofils ou microfils d'une structure électroluminescente 320 repose avantageusement sur le substrat support 380.

La pluralité de structures électroluminescentes 320 peut être agencée, par exemple, sous forme matricielle.

Par « forme matricielle », on entend un maillage à N lignes et M colonnes. Chaque structure électroluminescente 320 est alors disposée à l'intersection d'une ligne avec une colonne du maillage.

Une couche intermédiaire 370 comprenant un oxyde transparent conducteur, notamment un alliage d'oxyde d'indium et de titane, peut être formée en contact direct avec la face électroluminescente 330 de chacune des structures électroluminescentes 320.

La couche intermédiaire 370 peut être formée par des techniques connues de l'homme du métier.

L'étape a) est alors suivie d'une étape b) d'assemblage qui comprend la mise en contact des structures électroluminescentes 320 selon leur face arrière 340 avec une face, dite face d'accueil 510, d'un substrat d'accueil 500 (figure 2d).

La face d'accueil 510 peut en particulier comprendre des moyens d'interconnexion 520 agencés, en combinaison avec l'électrode commune 360a, pour adresser de manière individuelle chacune des structures électroluminescentes 320.

Les moyens d'interconnexion 520 peuvent par exemple comprendre un réseau de billes métalliques (« bail grid array » selon la terminologie anglo-saxonne). Les billes métalliques peuvent par exemple comprendre de l'indium.

De manière alternative, les moyens d'interconnexion 520 peuvent comprendre des structures colonnaires (« pillar » selon la terminologie anglo-saxonne). Les structures colonnaires peuvent par exemple comprendre un empilement de 3 µm de cuivre, 1 µm de nickel, 3 µm d'étain et 1 µm de nickel.

Lors de l'exécution de l'étape b) d'assemblage, les moyens d'interconnexion 520 sont mis en contact avec les faces arrière 340 des structures électroluminescentes 320.

L'étape b) peut être exécutée en pressant la structure temporaire 200 contre le substrat d'accueil 500.

L'étape b) peut également impliquer un collage direct de la structure temporaire 200 et du substrat d'accueil 500.

L'étape b) est alors suivie d'une étape c) de retrait, au moins partiel, du substrat temporaire 400.

L'étape c) peut être exécutée par abrasion mécanique (« grinding » selon la terminologie anglo-saxonne) (figures 2e, 3 et 4).

Ainsi, l'issue de l'étape c), les structures électroluminescentes 320 reposent sur la face d'accueil 510 et sont connectées par leur face arrière 340 aux moyens d'interconnexion 520.

L'électrode commune 360a formée par la couche d'adhésion 360 assure, avec les moyens d'interconnexion 520, le maintien mécanique entre les différentes structures électroluminescentes.

A cet égard, la couche d'adhésion, selon un premier mode de mise en œuvre, peut être formée de manière à recouvrir intégralement les faces électroluminescentes 330 et les tranchées 350.

De manière avantageuse, le matériau polymère formant la couche d'adhésion peut être, au moins partiellement transparent au rayonnement lumineux.

Par « au moins partiellement transparent au rayonnement lumineux », on entend généralement un matériau polymère organique dont le coefficient d'extinction dans la gamme de longueurs d'ondes couverte par le rayonnement lumineux est inférieur à 1%.

Le matériau polymère peut comprendre un matériau polymère organique.

En particulier, le matériau polymère peut comprendre : du poly(3,4-ethylenedioxythiophene): poly(styrenesulfonate) (Pedot :PSS), Poly(fluorene)s, polyphenylenes, polypyrenes, Polyazulenes, polynaphthalenes, poly(pyrrole)s (PPY), polycarbazoles, polyindoles, polyazepines, polyanilines (PANI), poly(thiophene)s (PT), poly(p-phenylene sulfide) (PPS), Poly(acetylene)s (PAC), Poly(p-phenylene vinylene) (PPV).

Le Pedot :PSS, qui présente une conductivité électrique de l'ordre de 4^{∗}10⁵ S/m, est particulièrement adapté pour former l'électrode commune 360a.

Le matériau polymère peut également comprend un colle chargée en espèces métalliques par exemple de l'argent. A cet égard, la colle EPO-TEK H2OE présente une conductivité électrique de l'ordre de 2,5^{∗}10⁵ S/m.

Le matériau polymère peut également comprendre des polymères, intrinsèquement non conducteur, chargés avec des éléments conducteurs nanométriques (exemple avec des nano fils d'argent/AI). La référence [2] citée à la fin de la description en donne un exemple.

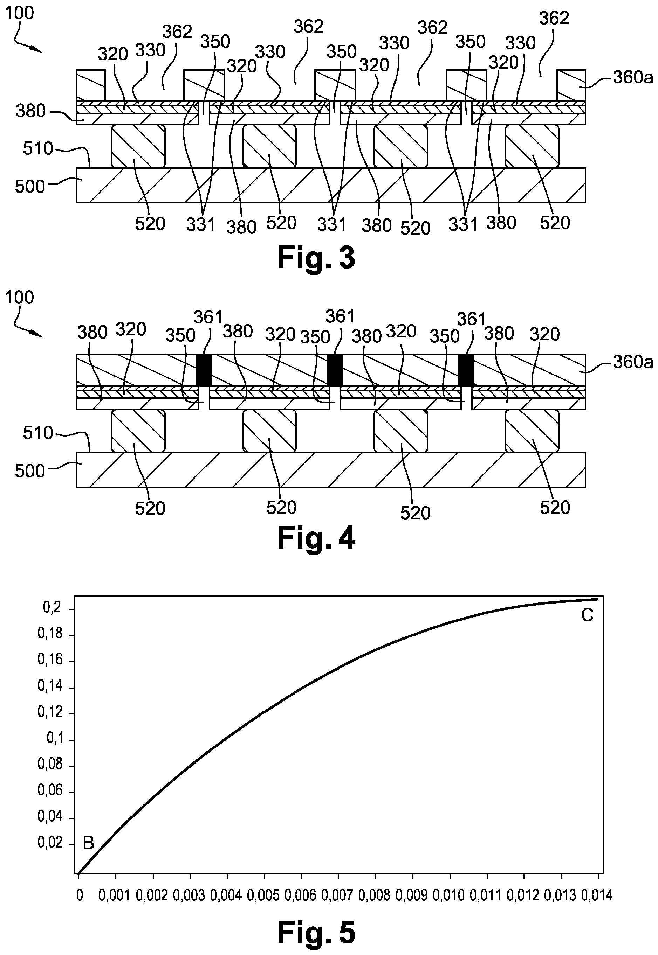

A cet égard, les inventeurs ont simulé le comportement, et en particulier l'évolution du potentiel de masse d'une électrode commune faite de Pedot :PSS, et présentant une épaisseur de 10 µm. Pour effectuer cette simulation, la densité de courant traversant l'électrode commune était égale à 7500 A/m². Tel que représenté à la figure 5, la différence de potentiel de 200 mV observée entre le centre C et le bord B de l'électrode commune reste compatible avec une alimentation matricielle pour laquelle une densité de courant donnée doit être imposée.

L'épaisseur de l'électrode commune 360a peut être supérieure à 20 nm, avantageusement supérieure à 500 nm, encore plus avantageusement supérieure à 1 µm, par exemple supérieur à 10 µm.

Un tel agencement de l'électrode commune 360a, et en particulier son épaisseur, permet une meilleure tenue mécanique de ladite électrode en particulier au niveau des tranchées 350. En d'autres termes cet agencement permet de prévenir toute rupture mécanique de l'électrode commune au niveau des tranchées 350 pouvant survenir par exemple lors de l'étape b).

De manière similaire à ce premier mode de réalisation, des ouvertures traversantes 362 peuvent être formées au niveau de l'électrode commune 360a.

La formation des ouvertures traversantes 362 peut intervenir dès la formation de la couche d'adhésion 360 lors de l'étape a), ou à l'issue de l'étape c) de retrait du substrat temporaire 210.

La formation des ouvertures traversantes 362 peut être exécutée par gravure sèche ou liquide.

Les ouvertures traversantes 362 sont, en particulier, formées pour exposer en partie les faces électroluminescentes 330, et conserver la couche d'adhésion 360 en recouvrement des tranchées 350 et sur un contour 331 d'une largeur prédéterminée des faces électroluminescentes 330. Il est entendu que le contour 331 est contigu aux tranchées 350 de sorte que la couche d'adhésion assure une liaison mécanique entre deux structures électroluminescentes 320 adjacentes.

La largeur prédéterminée peut être comprise entre 0,5 µm et 25 µm, avantageusement entre 0,5 µm et 10 µm, et encore plus avantageusement entre 0,5 et 5 µm.

Dès lors que des ouvertures traversantes 362 sont formées, il peut être avantageux de considérer la présence de la couche intermédiaire 370, en particulier dans le cadre d'une structure électroluminescente 320 faite de nanofils.

Les ouvertures traversantes permettent de considérer des matériaux polymères organiques relativement peu transparents, voire opaques, au rayonnement lumineux.

A cet égard, selon ce second mode de réalisation, le matériau polymère peut comprendre au moins un des éléments choisi parmi : Les colles polymères chargée de particules conductrices métalliques telles que des particules de cuivre d'argent ou d'or. Les bases de polymères peuvent comprendre au moins un des matériaux choisi parmi : époxy, acrylates, silicones, polyuréthane, matrices sol-gel.

Il est également possible de charger une matrice polymère photosensible (résine photlithographique) pour la rendre conductrice.

Selon un second mode de réalisation, la couche d'adhésion 360 peut comprendre des secondes tranchées 361 formées de manière conforme aux tranchées 350.

Par « formées de manière conforme », on entend des secondes tranchées 361 présentant essentiellement la même géométrie. En d'autres termes, les tranchées 350 et les secondes tranchées 361 sont essentiellement image l'une de l'autre.

Selon ce second mode de réalisation, les secondes tranchées 361 peuvent être comblées par un matériau conducteur, le matériau conducteur comprenant avantageusement un oxyde transparent conducteur, de manière à assurer une continuité électrique au niveau de l'électrode commune 360a.

Ainsi, selon la présente invention, la couche d'adhésion faite d'un matériau polymère organique est conservée à la fin du procédé de fabrication et forme une électrode commune.

Le procédé ainsi proposé est simplifié par rapport aux procédés connus de l'état la technique.

Par ailleurs, la tenue mécanique conférée par l'épaisseur de l'électrode permet de fiabiliser le procédé de fabrication et en particulier le dispositif électroluminescent formé par ledit procédé.

Plus particulièrement, la souplesse de l'électrode commune conférée par sa nature permet d'accepter une certaine tolérance en termes de non planéité des faces mises en regard lors de l'étape b).

### RÉFÉRENCES

[1] FR3012676 ;
[2] Jiongxin Lu et al., « Development of Novel Silver Nanoparticles/Polymer Composites as High K Polymer Matrix by In-situ Photochemical Method », Electronic Components and Technology Conference, 2006, Proceedings. 56th.

## Revendications

1. Procédé de fabrication d'un dispositif électroluminescent (100), comprenant :
a) une première étape de formation d'une structure temporaire (200) qui comprend une pluralité de structures électroluminescentes (320) individuelles séparées les unes des autres par des tranchées (350) et comprenant chacune une face, dite face électroluminescente (330), par laquelle lesdites structures sont susceptibles d'émettre un rayonnement lumineux, les structures électroluminescentes (320) étant collées selon leur face électroluminescente (330), au moyen d'une couche d'adhésion (360) sur une face, dite face temporaire (220), d'un substrat temporaire (210) ;
b) une étape d'assemblage qui comprend la mise en contact des structures électroluminescentes (320) selon une face opposée à la face électroluminescente (330) dite face arrière (340), avec une face, dite face d'accueil (510), d'un substrat d'accueil (500) ;
c) une étape de retrait, au moins partiel, du substrat temporaire (210) ;
le procédé étant **caractérisé en ce que** la couche d'adhésion (360), qui comprend un matériau polymère électriquement conducteur et au moins partiellement transparent au rayonnement lumineux, est, au moins en partie, conservée à l'issue de l'étape c) et forme une électrode commune (360a) aux faces électroluminescentes (330) dont l'épaisseur est supérieure à 20 nm, avantageusement supérieure à 500 nm, encore plus avantageusement supérieure à 1 µm.

2. Procédé selon la revendication 1, dans lequel l'étape a) comprend la formation de la couche d'adhésion (360) sur l'un ou l'autre du substrat temporaire (210) et d'un premier substrat (300), le premier substrat (300) comprenant sur une de ses faces, dite première face (310), la pluralité de structures électroluminescentes (320).

3. Procédé selon la revendication 2, dans lequel l'étape a) comprend en outre une étape d'assemblage, dite étape d'assemblage temporaire, du substrat temporaire (210) et du premier substrat (300), avantageusement, l'étape a) comprend également le retrait au moins partiel du premier substrat (300).

4. Procédé selon l'une des revendications 2 à 3, dans lequel une couche intermédiaire (370) comprenant un oxyde transparent conducteur est formée en contact direct des faces électroluminescentes (330) de chacune des structures électroluminescentes (320).

5. Procédé selon l'une des revendications 1 à 4, dans lequel le procédé de fabrication comprend en outre la formation d'ouvertures traversantes (362) dans la couche d'adhésion (360) exposant partiellement les faces électroluminescentes (330), les ouvertures traversantes (362) étant avantageusement formées par une étape de gravure sèche ou liquide.

6. Procédé selon la revendication 5, dans lequel la formation des ouvertures traversantes (362) est adaptée pour conserver une section de la couche d'adhésion (360) recouvrant les tranchées (350) et un contour d'une largeur prédéterminée des faces électroluminescentes (330).

7. Procédé selon la revendication 5 ou 6, dans lequel la formation des ouvertures traversantes est exécutée soit au cours de l'étape a), soit à l'issue de l'étape c).

8. Procédé selon l'une des revendications 1 à 4, dans lequel la couche d'adhésion (360) comprend des secondes tranchées (361) formées de manière conforme aux tranchées (350), et comblées par un matériau conducteur, le matériau conducteur comprenant avantageusement un oxyde transparent conducteur.

9. Procédé selon l'une des revendications 1 à 8, dans lequel le matériau polymère comprend au moins un des matériaux choisi parmi : poly(3,4-ethylenedioxythiophene): poly(styrenesulfonate) (Pedot :PSS), poly(fluorenes), polyphenylenes, polypyrenes, polyazulenes, polynaphthalenes, poly(pyrrole)s (PPY), polycarbazoles, polyindoles, polyazepines, polyanilines (PANI), poly(thiophene)s (PT), poly(p-phenylene sulfide) (PPS), poly(acetylene)s (PAC), poly(p-phenylene vinylene) (PPV).

10. Procédé selon l'une des revendications 1 à 9, dans lequel les structures électroluminescentes (320) comprennent, de leur face électroluminescente (330) vers leur face arrière (340), une couche électroluminescente reposant sur un substrat support présentant une épaisseur inférieure à 10 µm, avantageusement inférieur à 5 µm.

11. Procédé selon la revendication 10, dans lequel les structures électroluminescentes (320) comprennent chacune une couche active intercalée entre une première couche de semi-conducteur et une seconde couche de semi-conducteur.

12. Procédé selon la revendication 10, dans lequel la couche électroluminescente comprend une pluralité de nanofils perpendiculaires à la face électroluminescente (330).

13. Procédé selon l'une des revendications 1 à 12, dans lequel les structures électroluminescentes (320) sont agencées de manière matricielle.

14. Procédé selon l'une des revendications 1 à 12, dans lequel le substrat temporaire (210) n'est retiré que partiellement à l'étape c), et comprend un matériau dont la transmission optique dans le domaine de longueurs d'ondes couvert par le rayonnement lumineux est supérieure à 1%, avantageusement supérieure à 50%, encore plus avantageusement supérieure à 90%.

15. Procédé selon l'une des revendications 1 à 14, dans lequel le substrat d'accueil (500) comprend, sur sa face d'accueil (510), des moyens d'interconnexion, qui en combinaison avec l'électrode commune (360a), sont agencés pour adresser de manière individuelle chacune des structures électroluminescentes (320).

## Patentansprüche

1. Verfahren zur Herstellung einer Elektrolumineszenzvorrichtung (100), umfassend:
a) einen ersten Schritt des Bildens einer temporären Struktur (200), die eine Mehrzahl von individuellen Elektrolumineszenzstrukturen (320) umfasst, die voneinander durch Gräben (350) separiert sind und jeweils eine Fläche umfassen, genannt Elektrolumineszenzfläche (330), durch die die Strukturen eine Lichtstrahlung emittieren können, wobei die Elektrolumineszenzstrukturen (320) entlang ihrer Elektrolumineszenzfläche (330) mittels einer Adhäsionsschicht (360) auf eine Fläche, genannt temporäre Fläche (220), eines temporären Substrats (210) geklebt werden;
b) einen Zusammenfügungsschritt, der das Inkontaktbringen der Elektrolumineszenzstrukturen (320) entlang einer Fläche entgegengesetzt zu der Elektrolumineszenzfläche (330), genannt hintere Fläche (340), mit einer Fläche, genannt Empfangsfläche (510), eines Empfangssubstrats (500) umfasst;
c) einen Schritt des wenigstens partiellen Entfernens des temporären Substrats (210);
wobei das Verfahren **dadurch gekennzeichnet ist, dass** die Adhäsionsschicht (360), die ein Polymermaterial umfasst, das elektrisch leitend und wenigstens partiell für die Lichtstrahlung transparent ist, wenigstens teilweise am Ende des Schritts c) erhalten bleibt und eine gemeinsame Elektrode (360a) für die Elektrolumineszenzflächen (330) bildet, deren Dicke größer als 20 nm ist, vorzugsweise größer als 500 nm, noch weiter bevorzugt größer als 1 µm.

2. Verfahren nach Anspruch 1, bei dem der Schritt a) das Bilden der Adhäsionsschicht (360) auf dem einen oder dem anderen von dem temporären Substrat (210) und einem ersten Substrat (300) umfasst, wobei das erste Substrat (300) auf einer seiner Flächen, genannt erste Fläche (310), die Mehrzahl von Elektrolumineszenzstrukturen (320) umfasst.

3. Verfahren nach Anspruch 2, bei dem der Schritt a) ferner einen Schritt des Zusammenfügens, genannt temporärer Zusammenfügungsschritt, des temporären Substrats (210) und des ersten Substrats (300) umfasst, wobei der Schritt a) vorzugsweise ferner das wenigstens partielle Entfernen des ersten Substrats (300) umfasst.

4. Verfahren nach einem der Ansprüche 2 bis 3, bei dem eine Zwischenschicht (370), die ein transparentes leitendes Oxid umfasst, in direktem Kontakt der Elektrolumineszenzflächen (330) von jeder der Elektrolumineszenzstrukturen (320) gebildet wird.

5. Verfahren nach einem der Ansprüche 1 bis 4, bei dem das Herstellungsverfahren ferner das Bilden von durchgehenden Öffnungen (362) in der Adhäsionsschicht (360) umfasst, die die Elektrolumineszenzflächen (330) partiell freilegen, wobei die durchgehenden Öffnungen (362) vorzugsweise durch einen Schritt des Trocken- oder Flüssigätzens gebildet werden.

6. Verfahren nach Anspruch 5, bei dem das Bilden der durchgehenden Öffnungen (362) ausgelegt ist zur Bewahrung eines Abschnitts der Adhäsionsschicht (360), der die Gräben (350) bedeckt, und eines Umfangs einer vorbestimmten Breite der Elektrolumineszenzflächen (330).

7. Verfahren nach Anspruch 5 oder 6, bei dem das Bilden der durchgehenden Öffnungen entweder im Verlauf des Schritts a) oder am Ende des Schritts c) durchgeführt wird.

8. Verfahren nach einem der Ansprüche 1 bis 4, bei dem die Adhäsionsschicht (360) zweite Gräben (361) umfasst, die in einer zu den Gräben (350) entsprechenden Weise gebildet sind, und die mit einem leitenden Material gefüllt sind, wobei das leitende Material vorzugsweise ein leitendes transparentes Oxid umfasst.

9. Verfahren nach einem der Ansprüche 1 bis 8, bei dem das Polymermaterial wenigstens eines der Materialien umfasst, ausgewählt aus: Poly(3, 4-Ehtylendioxythiophen): Poly (Styrolsulfonat) (Pedot: PSS), Poly(Fluorene), Polyphenylene, Polypyrene, Polyazulene, Polynaphthalene, Poly(Pyrrole) (PPY), Polycarbazole, Polyindole, Polyazepine, Polyaniline (PANI), Poly(Thiophene) (PT), Poly(p-Phenylensulfid) (PPS), Poly(Acetylene) (PAC), Poly(p-Phenylenvinylene) (PPV).

10. Verfahren nach einem der Ansprüche 1 bis 9, bei dem die Elektrolumineszenzstrukturen (320) von ihrer Elektrolumineszenzfläche (330) in Richtung ihrer hinteren Fläche (340) eine Elektrolumineszenzschicht umfassen, die auf einem Trägersubstrat ruht, das eine Dicke von weniger als 10 µm aufweist, vorzugsweise weniger als 5 µm.

11. Verfahren nach Anspruch 10, bei dem die Elektrolumineszenzstrukturen (320) jeweils eine aktive Schicht umfassen, die zwischen einer ersten Halbleiterschicht und einer zweiten Halbleiterschicht eingefügt ist.

12. Verfahren nach Anspruch 10, bei dem die Elektrolumineszenzschicht eine Mehrzahl von Nanodrähten umfasst, die orthogonal zur Elektrolumineszenzfläche (330) sind.

13. Verfahren nach einem der Ansprüche 1 bis 12, bei dem die Elektrolumineszenzstrukturen (320) in Matrixweise angeordnet sind.

14. Verfahren nach einem der Ansprüche 1 bis 12, bei dem das temporäre Substrat (210) im Schritt c) nur partiell entfernt wird und ein Material umfasst, dessen optische Transmission in dem Wellenlängenbereich, der durch die Lichtstrahlung abgedeckt ist, größer als 1% ist, vorzugsweise größer als 50%, noch weiter bevorzugt größer als 90%.

15. Verfahren nach einem der Ansprüche 1 bis 14, bei dem das Empfangssubstrat (500) auf seiner Empfangsfläche (510) Verbindungsmittel umfasst, die in Kombination mit der gemeinsamen Elektrode (360a) dazu ausgelegt sind, jede der Elektrolumineszenzstrukturen (320) auf individuelle Weise zu adressieren.

## Claims

1. Method of making an electroluminescent device (100), comprising:
a) a first step for the formation of a temporary structure (200) that comprises a plurality of individual electroluminescent structures (320) separated from each other by trenches (350) and each comprising a face, called the light emitting face (330), through which said structures can emit light radiation, the electroluminescent structures (320) being bonded on their light emitting face (330) by means of a bond layer (360) on one face, called the temporary face (220), of a temporary substrate (210);
b) an assembly step that includes bringing the electroluminescent structures (320) into contact on a face called the back face (340) opposite the light emitting face (330), with a face called the host face (510) of a host substrate (500);
c) a step for at least partial removal of the temporary substrate (210);
the method being **characterised in that** the bond layer (360), that comprises an electrically conducting polymer material at least partially transparent to light radiation, is at least partly kept after step c) and forms an electrode (360a) common to the light emitting faces (330), with a thickness of more than 20 nm, advantageously more than 500 nm, and even more advantageously more than 1 µm.

2. Method according to claim 1, wherein step a) includes the formation of the bond layer (360) on either the temporary substrate (210) and a first substrate (300), the first substrate (300) comprising the plurality of electroluminescent structures (320) on one of its faces called the first face (310).

3. Method according to claim 2, wherein step a) also includes an assembly step called the temporary assembly step, to assemble the temporary substrate (210) and the first substrate (300), advantageously, step a) also comprises an at least partial removal of the first substrate (300).

4. Method according to one of claims 2 to 3, wherein an intermediate layer (370) comprising a transparent conducting oxide is formed in direct contact with the light emitting faces (330) of each of the electroluminescent structures (320).

5. Method according to one of claims 1 to 4, wherein the manufacturing method also includes the formation of through openings (362) in the bond layer (360), partially exposing the light emitting faces (330), the through openings (362) advantageously being formed during a dry or wet etching step.

6. Method according to claim 5, wherein the formation of through openings (362) is adapted to keep a section of the bond layer (360) covering the trenches (350) and a contour with a predetermined width of the light emitting faces (330).

7. Method according to claim 5 or 6, wherein the formation of through openings takes place either during step a) or after completion of step c).

8. Method according to one of claims 1 to 4, wherein the bond layer (360) comprises second trenches (361) formed to be conforming with the trenches (350), and filled in with a conducting material, the conducting material advantageously including a transparent conducting oxide.

9. Method according to one of claims 1 to 8, wherein the polymer material comprises at least material chosen from among: poly(3,4-ethylenedioxythiophene): poly(styrenesulfonate) (Pedot :PSS), Poly(fluorenes), polyphenylenes, polypyrenes, polyazulenes, polynaphthalenes, poly(pyrrole)s (PPY), polycarbazoles, polyindoles, polyazepines, polyanilines (PANI), poly(thiophene)s (PT), poly(p-phenylene sulfide) (PPS), poly(acetylene)s (PAC), poly(p-phenylene vinylene) (PPV).

10. Method according to one of claims 1 to 9, wherein the electroluminescent structures (320) comprise a light emitting layer resting on a support substrate with a thickness of less than 10 µm, and advantageously less than 5 µm, from their light emitting face (330) towards their back face (340).

11. Method according to claim 10, wherein each of the electroluminescent structures (320) comprises an active layer arranged between a first semiconducting layer and a second semiconducting layer.

12. Method according to claim 10, wherein the light emitting layer comprises a plurality of nanowires perpendicular to the light emitting face (330).

13. Method according to one of claims 1 to 12, wherein the electroluminescent structures (320) are arranged in matrix form.

14. Method according to one of claims 1 to 12, wherein the temporary substrate (210) is only partially removed in step c), and comprises a material for which the optical transmission in the wavelength range covered by the light radiation is more than 1%, advantageously more than 50%, and even more advantageously more than 90%.

15. Method according to one of claims 1 to 14, wherein, the host substrate (500) comprises interconnection means on its host face (510) that, in combination with the common electrode (360a), are arranged to individually address each of the electroluminescent structures (320).
